# EUROPÄISCHE PATENTSCHRIFT

(11) **EP 2 536 520 B1**
(45) Veröffentlichungstag und Bekanntmachung des Hinweises auf die Patenterteilung: **21.01.2015**
(21) Anmeldenummer: 11710416.6
(22) Anmeldetag: 17.02.2011
(51) Int. Cl.: B22D 45/00, B22D 41/46, B22D 41/22, C21C 5/46, C21C 5/52, F27D 19/00, F27D 21/00, F27B 14/20, F27D 3/14, H05K 5/00, H05K 7/20

(54) **ÜBERWACHUNGSEINRICHTUNG FÜR EINEN SCHIEBEVERSCHLUSS, EINEN GIESSROHRWECHSLER ODER EIN ANDERES VERSCHLUSSORGAN AN EINEM METALLURGISCHEN GEFÄSS**
MONITORING DEVICE FOR A SLIDING CLOSURE, A CASTING TUBE CHANGER OR ANOTHER CLOSURE ON A METALLURGICAL VESSEL
DISPOSITIF DE SURVEILLANCE POUR UN VERROU COULISSANT, UN DISPOSITIF DE CHANGEMENT DE TUBES DE COULÉE OU UN VERROU DIFFERENT, SUR UN RÉCIPIENT MÉTALLURGIQUE

(30) Priorität: 19.02.2010 CH 20912010
(43) Veröffentlichungstag der Anmeldung: 26.12.2012
(73) Patentinhaber: Stopinc Aktiengesellschaft, 6331 Hünenberg (CH)
(72) Erfinder: TRUTTMANN, Urs, CH-5033 Buchs (CH); INFANGER, Ivo, CH-6280 Hochdorf (CH)
(74) Vertreter: Luchs, Willi
(86) Internationale Anmeldenummer: PCT/EP2011/000751
(87) Internationale Veröffentlichungsnummer: WO 2011/101138

(56) Entgegenhaltungen:
- EP-A2- 1 260 345
- WO-A1-95/25255
- WO-A1-02/088400
- WO-A1-2010/025129

## Beschreibung

Die Erfindung betrifft eine Überwachungseinrichtung, gemäss Anspruch 1, für einen Schiebeverschluss, einen Giessrohrwechsler oder ein anderes Verschlussorgan an einem metallurgischen Gefäss, wobei die Einrichtung mit einer Elektronik zur Erfassung der im Giessbetrieb funktionswichtigen Parameter der überwachten Vorrichtung versehen st. Bevorzugte Ausführungsformen sind den Unteransprüchen 2-9 zu entnehmen.

Einrichtungen dieser Art werden beispielsweise bei Giesspfannen zur Funktionsüberwachung des am Pfannenausguss angeordneten Schiebeverschlusses eingesetzt. Sie haben die Aufgabe, während des Giessbetriebs die funktionswichtigen Parameter des Schiebeverschlusses zu erfassen und Veränderungen derselben anzuzeigen, um Betriebsstörungen vorzubeugen und schwerwiegende Betriebsausfälle zu vermeiden. Darüberhinaus eignen sie sich auch zur Automatisierung des Betriebsablaufs an der Pfannenstation der Giessanlage, etwa durch den Einsatz von roboterartigen Einrichtungen, insbesondere auch für die Datenaufzeichnung.

Bei solchen Überwachungseinrichtungen dient die Elektronik bekanntlich dazu, die während des gesamten Pfannenumlaufs etwa von einem Diagnosesystem des Schiebeverschlusses gelieferten Messdaten zuverlässig zu erfassen. Dazu zählen u.a. Druck- und Temperaturwerte sowie Verschleiss- und andere geometrische oder antriebstechnische Parameter. Anhand dieser Messdaten wird beispielsweise festgestellt, ob ein Austausch bestimmter Vorrichtungsteile oder gar der kompletten Vorrichtung angezeigt ist. Es ist bei den bekannten Überwachungseinrichtungen nachteilig, dass ihre in der Regel nahe der Giessvorrichtung plazierte Elektronik im Giessbetrieb den herrschenden rauhen Betriebsbedingungen, insbesondere der staubigen Luft bzw. einem Vakuum und der hohen Umgebungstemperatur ausgesetzt ist. Daraus können Fehldaten und somit Fehldiagnosen hinsichtlich des Betriebszustands des Schiebeverschlusses resultieren.

Die Druckschrift WO 95/25255 bezieht sich auf eine Einrichtung mit einem Gehäuse (cabinet) mit einem dieses durchfliessenden Luftstromes mittels eines Ventilators, in welchem Hitze erzeugende elektrische Komponenten gekühlt werden. Zudem sind in einer Kassetierung in dem Gehäuse isolierte Komponenten enthalten, welche separat durch den Ventilator und damit unabhängig von den andern elektrischen Komponenten gekühlt werden können. Das Gehäuse ist aber nicht direkt oder indirekt an einem metallurgischen Gefäss oder einem gleichsam erhitzten Ofen montiert.

In der Druckschrift WO 02/088400 ist erwähnt, dass die auftretende Hitze in elektrische Energie umgewandelt werden kann. Es ist aber nicht auf ein an einem Gefäss angeordnete Elektronik für einen Schiebeverschluss oder dergleichen hingewiesen.

Bei einer Spritzgiessmaschinenanordnung gemäss der Druckschrift EP-A 1 260 345 ist geoffenbart, dass ein internes Maschinensteuerungssystem sowie mindestens eine Stromnetzübertragungseinheit vorgesehen sind. Es ist bei den bekannten Überwachungseinrichtungen nachteilig, dass ihre in der Regel nahe der Giessvorrichtung plazierte Elektronik im Giessbetrieb den herrschenden rauhen Betriebsbedingungen, insbesondere der staubigen Luft bzw. einem Vakuum und der hohen Umgebungstemperatur ausgesetzt ist. Daraus können Fehldaten und somit Fehldiagnosen hinsichtlich des Betriebszustands des Schiebeverschlusses resultieren.

Der Erfindung liegt die Aufgabe zugrunde, diese Nachteile zu vermeiden und eine Überwachungseinrichtung der eingangs genannten Art zu schaffen, deren Elektronik während des Giessbetriebs gegen Störeinflüsse aus der Umgebung geschützt ist.

Diese Aufgabe wird erfindungsgemäss dadurch gelöst, dass die Elektronik wenigstens in einer am Gefäss, am Schiebeverschluss, am Giessrohrwechsler oder dergleichen anbringbaren separaten Einheit eingebaut ist, welche eine Schutzfunktion der Elektronik ausübt.

Auf diese Weise ist sichergestellt, dass die Elektronik stets bei einer für sie geeigneten Raumtemperatur arbeiten kann, die im Innenraum der Einheit niedriger ist als die Umgebungstemperatur in der Anlage. Darüberhinaus ist die Einheit von der Umgebung weitgehend abgeschlossen, so dass sie ohne grossen Aufwand einen staubfreien Innenraum aufweisen kann.

Mit der Elektronik können Überwachungsarbeiten an einem Schiebeverschluss, einem Giessrohrwechsler oder dergleichen als auch an dem Gefäss selbst vorgenommen werden, ohne dass entsprechende Kabelverbindungen vom metallurgischen Gefäss zu einer Zentrale bestehen müssen. Dies kann insbesondere dann von Vorteil sein, wenn das Gefäss, wie zum Beispiel eine Stahlschmelze enthaltende Pfanne, mittels eines Krans vom Pfannenplatz zu einer Füllstation und weiter zu einer Behandlungsstation und folglich auf die Giessbühne gebracht wird. Dementsprechend müssen gegebenenfalls Kabelverbindungen an der jeweiligen Station gesteckt bzw. gelöst werden.

Die Erfindung sieht ferner vor, dass die Einheit mit einem aktiven Kühlsystem versehen ist. Damit kann eine starke Kühlwirkung erzielt werden, die zudem leicht von Fall zu Fall auf die jeweiligen Arbeitsbedingungen der Anlage einstellbar ist.

Es ist im Sinne einer konstruktiv einfachen Anordnung vorteilhaft, wenn das Kühlsystem erfindungsgemäss durch eine Luftkühlung mit mindestens einem Ventilator gebildet ist, der vorzugsweise mit einer von der Abwärme des Gefässes gespeisten Energiequelle antreibbar ist. Ein derartiges Kühlsystem ist energiesparend und zugleich hinreichend robust, um unter rauhen Betriebsbedingungen zu arbeiten.

Die Erfindung sieht ferner vor, dass der Ventilator zusätzlich mit einer externen Energiequelle antreibbar ist. Sie hat die Aufgabe, Schwankungen der abwärmeabhängigen Energieversorgung auszugleichen. Erforderlichenfalls kann sie auch die volle Energieversorgung des Ventilators übernehmen.

Zweckmässigerweise sind beide Energiequellen stromerzeugend, wobei der Ventilator elektrisch mit dem von ihnen gelieferten Strom antreibbar ist.

Gemäss der Erfindung vorgesehen, dass die Einheit mit einer Wärmeisolierung versehen ist.

Zwecks eines möglichst hohen wärmeisolierenden Effekts ist die Einheit so ausgebildet, dass sie zwei ineinanderliegende Isolierkammern bildet, wobei die Wärmeisolierung in der aussenliegenden Kammer angeordnet ist und die Elektronik in der innenliegenden Kammer eingebaut und dort durch eine Isolierwand zum Gefäss hin abgeschirmt ist.

Die Erfindung sieht ausserdem vor, dass die Einheit mit einer Luftfiltereinrichtung versehen ist. Damit wird verhindert, dass die staubhaltige Umgebungsluft die Funktion der Elektronik beeinträchtigt.

Nachfolgend wird die Erfindung anhand eines Ausführungsbeispiels unter Bezugnahme auf die Zeichnung näher beschrieben.

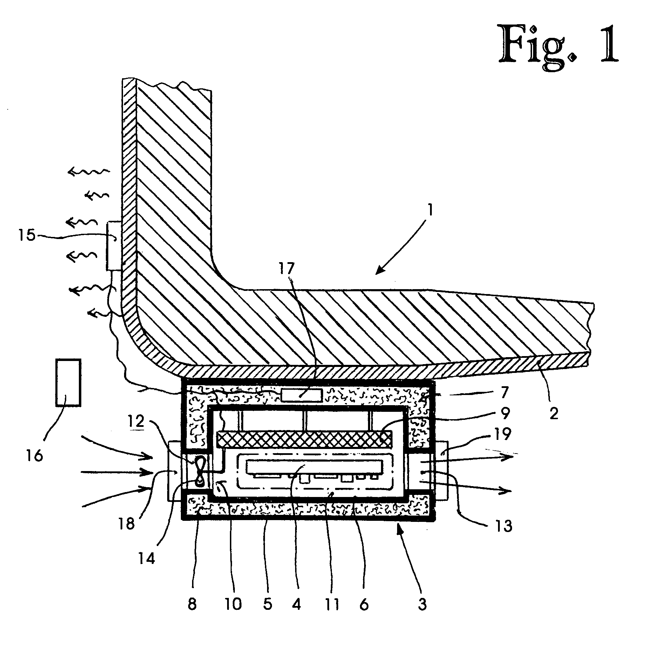

- Fig. 1: zeigt eine Giesspfanne mit einer erfindungsgemässen Einheit, im Schnitt und schematisch dargestellt.

In Fig. 1 ist ein Teilbereich der Giesspfanne 1 sichtbar, an deren Aussenmantel 2 erfindungsgemäss eine separate Einheit 3 mit der Elektronik 4 zum Schutze von letzterer einer sonst nicht dargestellten Überwachungseinrichtung für einen Schiebeverschluss, einen Giessrohrwechsler oder eine ähnliche Giessvorrichtung befestigt ist. Diese Einheit 3 ist zum Beispiel wie eine thermische Schutzbox ausgebildet.

Diese separate Einheit 3 weist ein Aussengehäuse 5 und ein Innengehäuse 6 auf, wobei der Zwischenraum 7 zwischen beiden Gehäusen mit einer Wärmeisolierung 8 versehen ist. Die Elektronik 4 ist im Innengehäuse 6 untergebracht und dort mit einer Isolierwand 9 zur Giesspfanne 1 zusätzlich abgeschirmt.

In der Einheit 3 ist eine Kühlungseinrichtung 10 angeordnet, durch welche der Innenraum 11 der Einheit aktiv mit Kühlluft oder einem andern Kühlmittel, wie beispielsweise Argongas, Stickstoff oder ähnlichem gekühlt wird. Hierfür sind vorteilhaft an den Seitenwänden der Einheit 3 eine Kühlluft-Einlassöffnung 12 und eine Abluft-Auslassöffnung 13 in Höhe der Elektronik 4 vorgesehen. In der Einlassöffnung 12 ist ein elektrisch angetriebener Ventilator 14 angeordnet. Dieser wird mit einer von der Abwärme der Giesspfanne 1 gespeisten Energiequelle 15 angetrieben, welche die thermische Energie in elektrische Energie für den Elektroantrieb des Ventilators umwandeln kann.

Ausserdem ist eine externe Energiequelle 16 vorgesehen, mit welcher der Ventilator 14 ebenfalls elektrisch antreibbar ist. Beide Energiequellen 15 und 16 sind an einem Akkumulator 17 angeschlossen. Dadurch wird eine gleichmässige Stromversorgung des Ventilators 14 während des gesamten Pfannenumlaufs sichergestellt.

An den Seitenwänden der Einheit sind vor den Einlass- und Auslassöffnungen 12, 13 Luftfilter 18, 19 angeordnet. Sie verhindern, dass Luftverunreinigungen die Funktion der Elektronik 4 beeinträchtigen.

Die vom Ventilator 14 bewirkte Kühlung gewährleistet, dass die Raumtemperatur im Innenraum 11 der Einheit einen für den störungsfreien Betrieb der Elektronik 4 geeigneten Grenzwert nicht überschreitet. Zweckmässigerweise könnte auch eine Temperaturregelung in dem Innenraum 11 erfolgen, indem die Temperatur gemessen und mit einem Sollwert verglichen, und bei Abweichung der Ventilator ein- oder ausgeschaltet bzw. mit einer höheren oder tieferen Drehzahl versehen würde. Damit könnte eine konstante Solltemperatur in dieser Einheit erzielt werden.

Anstelle der Luftkühlung 10 können selbstverständlich andere vergleichbare Kühlsysteme eingesetzt werden, die auch eine robuste Konstruktion aufweisen und mit einfachen Antriebs- bzw. Energieversorgungsmitteln betreibbar sind.

Zweckmässigerweise befindet sich die Einheit an einer gut zugänglichen Stelle der Giesspfanne, nahe an der zu überwachenden Vorrichtung. Diese ist mit einer Steck- oder ähnlichen Verbindung als Schnittstelle an die Elektronik der Überwachungseinrichtung anschliessbar.

Die Elektronik umfasst übliche Bestandteile, ähnlich wie bei einem Computer, namentlich Prozessor/en, Speicher, Funkeinrichtung (Bluetooth etc.), Schnittstellen, mitunter auch für den Datenaustausch mit wenigstens einem Peripheriegerät (Computer), wobei dieser elektronische Datenaustausch insbesondere zum Empfangen und Abspeichern von Daten aus dieser Elektronik dient.

Mit diesen elektronischen Überwachungsarbeiten können verschiedene Messungen, wie zum Beispiel Temperaturmessungen, sowohl beim Gefäss selbst als auch beim Schiebeverschluss oder dergleichen durchgeführt und in der Elektronik sogar ausgewertet werden.

Mit dieser Überwachungseinrichtung kann überdies eine off- und/oder online Diagnose des Betriebszustandes eines Schiebeverschlusses oder dergleichen zum Beispiel im Bereich der Feuerfestteile, wie Verschlussplatten, oder im Gehäuse, beim Antriebsorgan und/oder an anderen Stellen erfolgen, mittels denen Abmessungen, Temperaturen, Drücke und/oder Kräfte gemessen und anschliessend ausgewertet werden.

Mit dieser Elektronik können bei der Auswertung die als Istwerte gemessenen Grössen mit Sollwerten oder Sollwertbereichen verglichen und bei Vorliegen von Abweichungen ausserhalb der zu bestimmenden Toleranzgrenzen eine Anzeige oder dergleichen für eine Überprüfung oder ein Notschliessen des Schiebeverschlusses ausgelöst werden.

Durch eine Funkverbindung in dieser Elektronik könnten auch Daten an eine Station übermittelt und an dieser weiterverarbeitet werden.

Die Erfindung ist mit dem oben erläuterten Ausführungsbeispiel ausreichend dargetan. Sie könnte aber noch durch andere Beispiele ausgeführt sein. So könnte auf die Isolierwand 9 in der innenliegenden Kammer 11 verzichtet werden. Bei dem aktiven Kühlsystem könnte es sich auch um ein Kühlschlange oder dergleichen handeln.

Es könnte aber auch ein passives Kühlsystem vorgesehen sein, bei dem beispielsweise die Isolation der Einheit einen ausreichenden Schutz für die Elektronik bieten würde.

Eine solche Einheit könnte aber nicht nur am Gefäss, sondern auch am Schiebeverschluss, am Giessrohrwechsler oder dergleichen angebracht sein. Dies hängt von den Platz- bzw. Temperaturverhältnissen beim metallurgischen Gefäss ab, bei welchem es sich um eine Pfanne, ein Konverter, ein Tundish oder einen Ofen handeln kann.

## Patentansprüche

1. Überwachungseinrichtung für einen Schiebeverschluss, einen Giessrohrwechsler oder ein anderes Verschlussorgan an einem metallurgischen Gefäss, wobei die Einrichtung mit einer Elektronik (4) zur Erfassung der im Giessbetrieb funktionswichtigen Parameter der überwachten Vorrichtung bzw. des überwachten Gefässes versehen ist, **dadurch gekennzeichnet, dass**
die Elektronik (4) in wenigstens einer am Gefäss (1), am Schiebeverschluss, am Giessrohrwechsler oder am Verschlussorgan anbringbaren separaten Einheit (3) eingebaut ist, welche eine Schutzfunktion der Elektronik (4) ausübt und mit einer Wärmeisolierung (8) versehen ist.

2. Überwachungseinrichtung nach Anspruch 1 , **dadurch gekennzeichnet, dass** die Einheit (3) mit einem aktiven Kühlsystem (10) als Schutzfunktion versehen ist.

3. Überwachungseinrichtung nach Anspruch 2, **dadurch gekennzeichnet, dass** das Kühlsystem (10) durch eine Luft- oder Gaskühlung mit mindestens einem Ventilator (14) gebildet ist.

4. Überwachungseinrichtung nach Anspruch 3, **dadurch gekennzeichnet, dass** der Ventilator (14) mit einer von der Abwärme des Gefässes (1) gespeisten Energiequelle (15) und einer externen Energiequelle (16) antreibbar ist.

5. Überwachungseinrichtung nach einem der Ansprüche 1 bis 4, **dadurch gekennzeichnet, dass** eine Einrichtung zur Temperaturregelung in dem Innenraum (11) der Einheit (3) vorgesehen ist, mittels welcher die Temperatur in der Einheit gemessen und mit einem Sollwert verglichen, und bei Abweichung das Kühlsystem (10) entsprechend ansteuerbar ist.

6. Überwachungseinrichtung nach Anspruch 4 oder 5, **dadurch gekennzeichnet, dass** der Ventilator (14) elektrisch mit von der Energiequelle (15, 16) geliefertem Strom antreibbar ist.

7. Überwachungseinrichtung nach Anspruch 1, **dadurch gekennzeichnet, dass** die Einheit (3) mindestens zwei ineinanderliegende Isolierkammern (7, 11) bildet, wobei die Wärmeisolierung (8) in der aussenliegenden Kammer (7) angeordnet ist und die Elektronik (4) in der innenliegenden Kammer (11) eingebaut und dort durch eine Isolierwand (9) zum Gefäss (1) hin abgeschirmt ist.

8. Überwachungseinrichtung nach einem der Ansprüche 1 bis 7, **dadurch gekennzeichnet, dass** die Einheit (3) mit einer Luftfiltereinrichtung (8, 19) versehen ist.

9. Überwachungseinrichtung nach einem der Ansprüche 1 bis 8, **dadurch gekennzeichnet, dass** die Elektronik (4) Prozessor/en, Speicher, Funkeinrichtung und/oder Schnittstellen, auch für den Datenaustausch mit wenigstens einem Peripheriegerät (Computer) umfasst.

## Claims

1. Monitoring device for a sliding closure, a casting tube changer or another closure device on a metallurgical vessel, whereby the device being provided with an electronics system (4) for detecting the parameters of the monitored apparatus respectively of the monitored vessel that are functionally important during casting, **characterised in that**
the electronics system (4) is housed in at least one separate unit (3) that can be attached to the vessel (1), to the sliding closure, the casting tube changer or the closure device, and which performs the function of protecting the electronics system (4) and is equipped with a heat insulation (8).

2. Monitoring device according to Claim 1, **characterised in that** the unit (3) is provided with an active cooling system (10) as a protective function.

3. Monitoring device according to Claim 2, **characterised in that** the cooling system (10) is formed by an air or gas cooling system having at least one ventilator (14).

4. Monitoring device according to Claim 3, **characterised in that** the ventilator (14) can be driven by an energy source (15) supplied by the waste heat of the vessel (1) and an external energy source (16).

5. Monitoring device according to any of the Claims 1 to 4, **characterised in that** a device is provided to regulate the temperature in the interior (11) of the unit (3), by means of which the temperature in the unit is measured and compared with a desired value, and if there is a deviation the cooling system (10) can be appropriately controlled.

6. Monitoring device according to Claim 4 or 5, **characterised in that** the ventilator (14) can be driven electrically by current supplied by the energy source (15, 16).

7. Monitoring device according to Claim 1, **characterised in that** the unit (3) forms at least two insulating chambers (7, 11) one lying inside the other, whereby the heat insulation (8) being located in the outermost chamber (7) and the electronics system (4) being housed in the innermost chamber (11) and being shielded there by an insulating wall (9) with respect to the vessel (1).

8. Monitoring device according to any of the Claims 1 to 7, **characterised in that** the unit (3) is provided with an air filter device (8, 19).

9. Monitoring device according to any of the Claims 1 to 8, **characterised in that** the electronics system (4) includes processor/s, memory, radio device and/or interfaces, preferably also for data exchange with at least one peripheral device (computer).

## Revendications

1. Dispositif de contrôle d'une busette à tiroir, d'un dispositif de changement de tube de coulée ou d'un autre organe de fermeture sur un récipient métallurgique, le dispositif étant pourvu d'une électronique (4) de détection des paramètres importants pour le fonctionnement en coulée du dispositif contrôlé ou du récipient contrôlé, **caractérisé en ce que**
l'électronique (4) est incorporée dans au moins une unité (3) distincte pouvant être mise sur le récipient (1), sur la busette à tiroir, sur le dispositif de changement de tube ou sur l'organe de fermeture, unité qui exerce une fonction de protection de l'électronique (4) et qui est pourvue d'un calorifugeage (8).

2. Dispositif de contrôle suivant la revendication 1, **caractérisé en ce que** l'unité (3) est pourvue d'un système (10) de refroidissement actif en tant que fonction de protection.

3. Dispositif de contrôle suivant la revendication 2, **caractérisé en ce que** le système (10) de refroidissement est formé par un refroidissement par de l'air ou par du gaz ayant au moins un ventilateur (14).

4. Dispositif de contrôle suivant la revendication 3 **caractérisé en ce que** le ventilateur (14) peut être entraîné par une source (15) d'énergie alimentée par la chaleur perdue de récipient (1) et par une source (15) d'énergie extérieure.

5. Dispositif de contrôle suivant l'une des revendications 1 à 4, **caractérisé en ce qu'**il est prévu un dispositif de régulation de la température à l'intérieur (11) de l'unité (3), dispositif de régulation de la température au moyen duquel la température dans l'unité est mesurée et est comparée à une valeur de consigne et, s'il y a écart, le système (10) de refroidissement peut être commandé en conséquence.

6. Dispositif de contrôle suivant la revendication 4 ou 5, **caractérisé en ce que** le ventilateur (14) peut être entraîné électriquement par du courant fourni par la source (15, 16) d'énergie.

7. Dispositif de contrôle suivant la revendication 1, **caractérisé en ce que** l'unité (3) forme au moins deux chambres (7, 11) isolées juxtaposées, le calorifugeage (8) étant disposé dans la chambre (7) se trouvant à l'extérieur et l'électronique (4) étant incorporée dans la chambre (11) intérieure et y étant protégée par une paroi (9) isolante par rapport au récipient (1).

8. Dispositif de contrôle suivant l'une des revendications 1 à 7, **caractérisé en ce que** l'unité (3) est pourvue d'un dispositif (8, 9) de filtration de l'air.

9. Dispositif de contrôle suivant l'une des revendications 1 à 8, **caractérisé en ce que** l'électronique (4) comprend un processeur ou des processeurs, une mémoire, un dispositif radio et/ou des interfaces également pour l'échange de données avec au moins un appareil périphérique (ordinateur).
